# EUROPEAN PATENT APPLICATION

(11) **EP 4 683 119 A2**
(43) Date of publication of application: **21.01.2026**
(21) Application number: 25181248.3
(22) Date of filing: 06.06.2025
(51) Int. Cl.: H01R 4/70, H01R 4/34, H01R 11/28

(54) **ELECTRICAL ASSEMBLY**

(30) Priority: 16.07.2024 US 202418774134
(71) Applicant: Aptiv Technologies AG, 8200 Schaffhausen (CH)
(72) Inventor: FRANKO, Andrew, 8200 Schaffhausen (CH); WEIDNER, Jonathan D., 8200 Schaffhausen (CH)
(74) Representative: Bardehle Pagenberg Partnerschaft mbB Patentanwälte Rechtsanwälte

(57) **Abstract**

A cover includes a base, a pair of rails, and a leg. The pair of rails extend from the base and are configured to be moveably-coupled to a housing. The leg extends from the base and includes a detent that is configured to restrict movement of the cover relative to the housing.

## Description

### FIELD

The present disclosure relates to an electrical assembly and more particularly to an electrical assembly that may be used in connection with vehicles.

### BACKGROUND

Electric vehicles (EVs) are gaining popularity as environmentally friendly alternatives to traditional internal combustion engine vehicles. EVs include electrical assemblies that facilitate the electrical connection of a battery pack with an electrical system of the vehicle such that high electrical current can be transmitted from the battery pack to the electrical system. Exposure of the electrical connection to contamination (e.g., conductive material buildup, dirt, moisture, corrosion, etc.) can cause poor conductivity, operation failures, damage, and/or safety risks to passengers of the vehicle. While known electrical assemblies, have proven acceptable for their intended purpose, a continuous need for improvement remains in the pertinent art.

The background description provided here is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

### SUMMARY

One aspect of the disclosure provides a cover. The cover includes a base, a pair of rails, and a leg. The pair of rails extend from the base and are configured to be moveably-coupled to a housing. The leg extends from the base and includes a detent that is configured to restrict movement of the cover relative to the housing.

Another aspect of the disclosure provides an electrical assembly. The electrical assembly includes an electrical conductor, a housing, and a cover. The housing is removably coupled to the electrical conductor and defines a cavity and an aperture. The cavity receives at least a portion of the electrical conductor. The aperture is in fluid communication with the cavity. The cover is slidably coupled to the housing and is configured to move between an open position and a closed position.

Further areas of applicability of the present disclosure will become apparent from the detailed description, the claims, and the drawings. The detailed description and specific examples are intended for purposes of illustration only and are not intended to limit the scope of the disclosure.

### BRIEF DESCRIPTION OF THE DRAWINGS

The present disclosure will become more fully understood from the detailed description and the accompanying drawings.
FIG. 1 is an exploded perspective view of an example electrical assembly in accordance with the principles of the present disclosure.
FIG. 2 is a schematic view of the electrical assembly of FIG. 1 in accordance with the principles of the present disclosure.
FIG. 3 is a bottom perspective view of the electrical assembly of FIG. 1 in accordance with the principles of the present disclosure.
FIG. 4 is a perspective view of the electrical assembly of FIG. 1 in an open configuration in accordance with the principles of the present disclosure.
FIG. 5 is a cross-sectional view of the electrical assembly of FIG. 4 in accordance with the principles of the present disclosure.
FIG. 6 is a perspective view of the electrical assembly of FIG. 1 in a closed configuration in accordance with the principles of the present disclosure.
FIG. 7 is a cross-sectional view of the electrical assembly of FIG. 6 in accordance with the principles of the present disclosure.

In the drawings, reference numbers may be reused to identify similar and/or identical elements.

### DETAILED DESCRIPTION

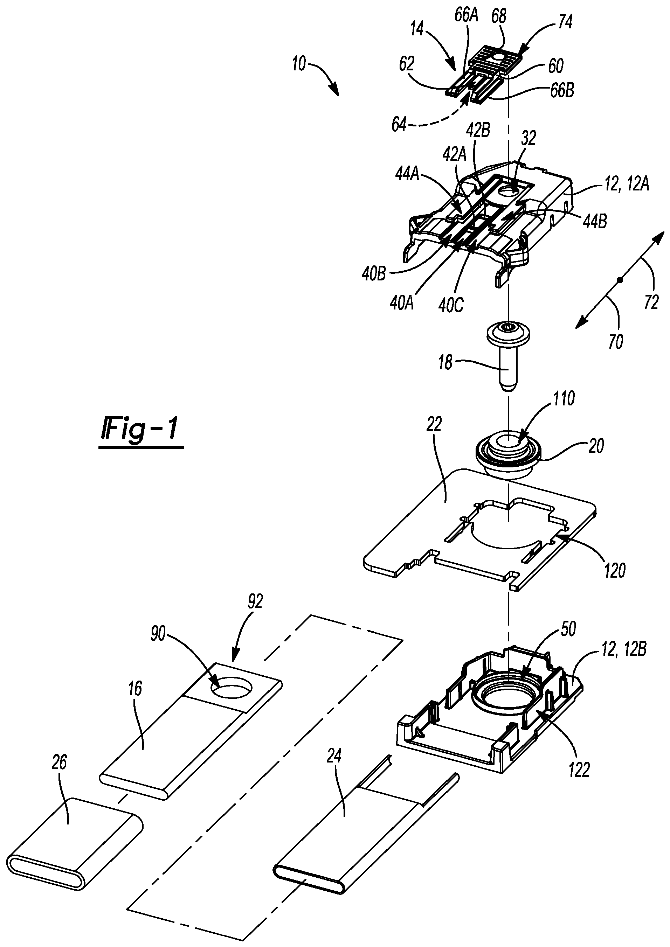

With reference to FIG. 1, an example electrical assembly 10 is shown. In various implementations, the electrical assembly 10 includes a housing 12, a cover 14, an electrical conductor 16, a fastener 18, an electrical terminal 20, a plate 22, a first sleeve 24, and/or a second sleeve 26, among others.

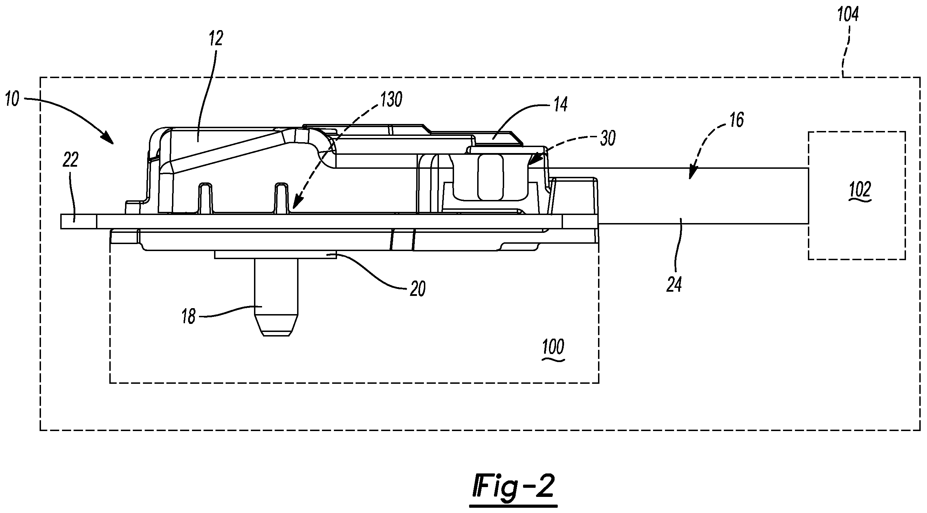

With reference to FIGS. 2-7, in an assembled configuration, the housing 12 is removably coupled with the electrical conductor 16 and/or the plate 22, among others. In various implementations, the housing 12 defines a cavity 30 and an aperture 32. The aperture 32 is in fluid communication with the cavity 30. The cavity 30 receives at least a portion of the electrical conductor 16 and/or at least a portion of the plate 22, among others. The aperture 32 receives at least a portion of the fastener 18.

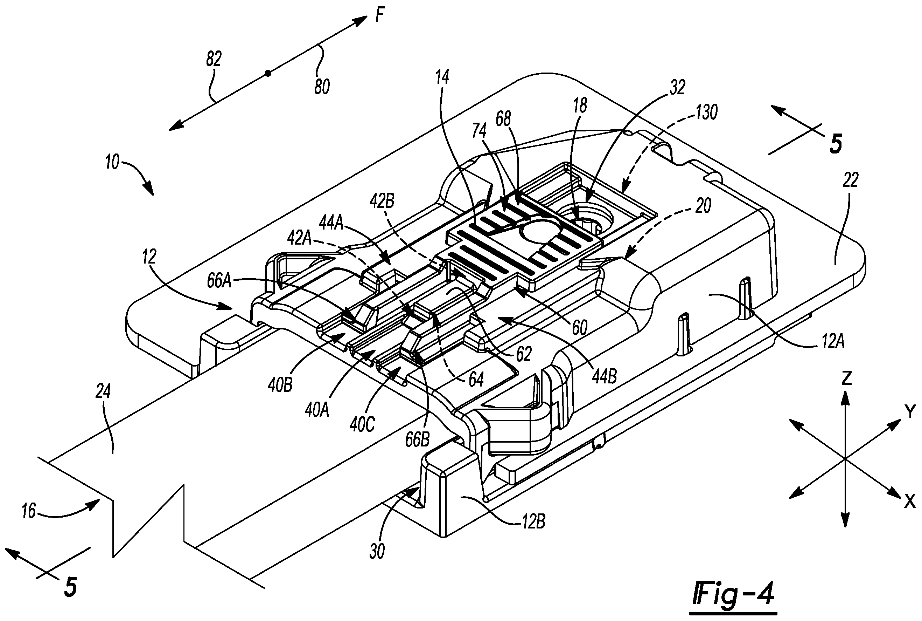

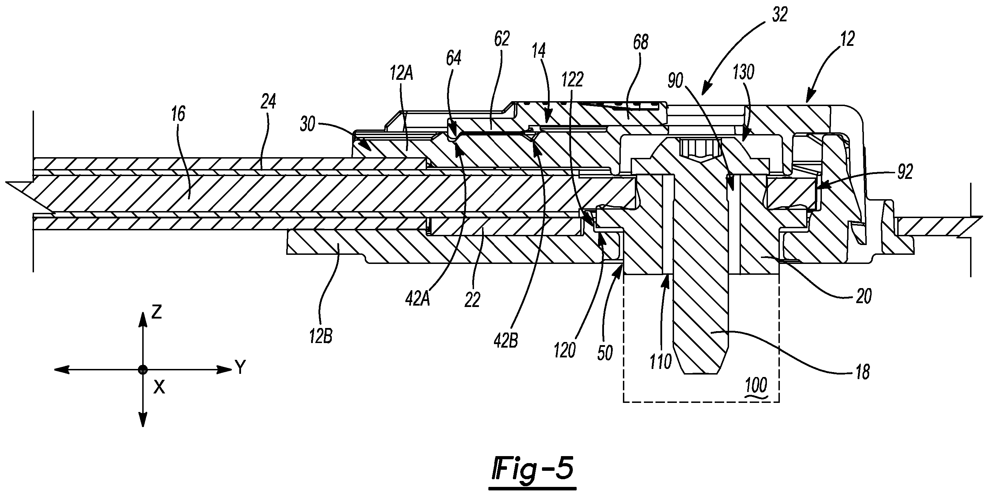

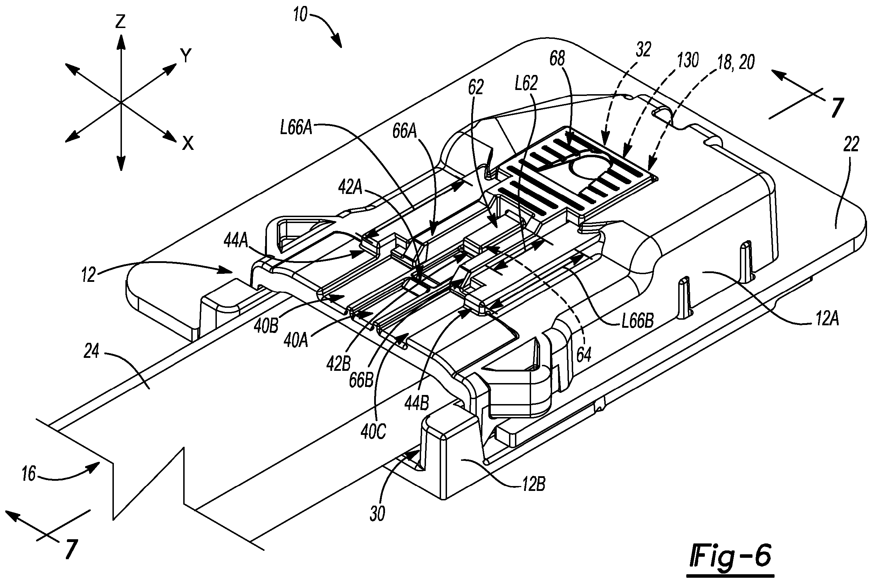

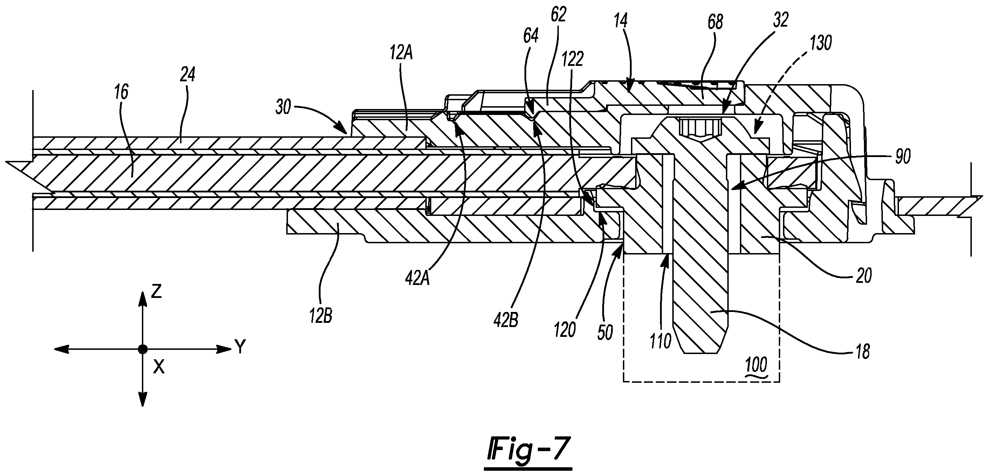

In various implementations, the cover 14 is slidably coupled to the housing 12. The cover 14 moves, relative to the housing 12, between an open position (see, e.g., FIGS. 4 and 5) and a closed position (see, e.g., FIGS. 6 and 7). In various implementations, the aperture 32 is exposed when the cover 14 is in the open position and/or the aperture 32 is covered when the cover 14 is in the closed position.

With reference to FIGS. 1 and 4, in various implementations, the housing 12 comprises one or more of a variety of shapes, sizes, configurations, and/or materials. In some example configurations, the housing 12 includes a first portion 12A and a second portion 12B. The first portion 12A may be removably coupled to the second portion 12B (e.g., via a snap-fit connection, one or more interlocking mechanisms, one or more fasteners, one or more latching mechanisms, an adhesive, among others). In the assembled configuration, the first portion 12A and the second portion 12B may define the cavity 30. Alternatively, the housing 12 may include a singular construct such as a single-piece design and/or a monolithic structure, among others.

In various implementations, the first portion 12A of the housing 12 defines the aperture 32, a first channel 40A, a second channel 40B, a third channel 40C, a first recess 42A, a second recess 42B, a first track 44A, and/or a second track 44B, among others. In various implementations, the first channel 40A is disposed between the second channel 40B and the third channel 40C. The first channel 40A, the second channel 40B, and the third channel 40C may be arranged parallel to each other.

In various implementations, the first recess 42A and the second recess 42B are in fluid communication with and/or are accessible via the first channel 40A. In various implementations, the first channel 40A, the second channel 40B, the third channel 40C, the first recess 42A, and/or the second recess 42B receive portions of the cover 14.

In various implementations, the first track 44A is disposed adjacent to and/or extends parallel to the second channel 40B. The second track 44B may be disposed adjacent to and/or may extend parallel to the third channel 40C. In various implementations, the first track 44A and the second track 44B receive and/or engage portions of the cover 14. In some example configurations, the first track 44A and/or the second track 44B include cross-sections that have L-shaped configurations.

In various implementations, the second portion 12B of the housing 12 defines an opening 50 (e.g., an aperture). In the assembled configuration, the opening 50 is aligned with the aperture 32 of the first portion 12A. The terminal 20 may be removably coupled to the second portion 12B and/or at least a portion of the terminal 20 may be disposed in the opening 50. The fastener 18 may be disposed in the aperture 32, the terminal 20, and the opening 50.

With reference to FIGS. 1 and 4-6, in various implementations, the cover 14 comprises one or more of a variety of shapes, sizes, configurations, and/or materials. In some example configurations, the cover 14 includes a base 60, at least one leg 62, at lease one detent 64, a first rail 66A, a second rail 66B, and/or a platform 68, among others. In some example configurations, the leg 62, the first rail 66A, and/or the second rail 66B may extend from the base 60 in a first direction 70. The leg 62 may be disposed between the first rail 66A and the second rail 66B. In various implementations, the platform 68 extends from the base in a second direction 72 that is opposite the first direction 70. In some example configurations, the first rail 66A includes a length L66A that is similar to a length L66B of the second rail 66B. The leg 62 may include a length L62 that is less than the length L66A of the first rail 66A and the length L66B of the second rail 66B (see, e.g., FIG. 6). In various implementations, the first rail 66A and the second rail 66B include cross-sections that have L-shaped configurations.

In various implementations, the leg 62 is received by the first channel 40A of the housing 12. The first rail 66A may be received by second channel 40B and/or the first track 44A of the housing 12. The second rail 66B may be received by third channel 40C and/or the second track 44B of the housing 12. In various implementations, when the first rail 66A is disposed in the first track 44A and the second rail 66B is disposed in the second track 44B, the cover 14 is inhibited from detaching from the housing 12. For example, the cover 14 is in inhibited from moving relative to the housing 12 in the X-direction and the Z-direction.

In various implementations, the detent 64 extends from the leg 62. The detent 64 may be received by the first recess 42A and the second recess 42B of the housing 12. For example, the detent 64 may be disposed in the first recess 42A when the cover 14 is in the open position (see, e.g., FIG. 5) and the detent 64 may be disposed in the second recess 42B when the cover 14 is in the closed position (see, e.g., FIG. 7). In various implementations, when the detent 64 is disposed in the first recess 42A or the second recess 42B, the cover 14 is in a locked state and is inhibited from moving relative to the housing 12. For example, the cover 14 is inhibited from moving relative to the housing 12 in the Y-direction. In various implementations, when the cover 14 is moving between the open configuration and the closed configuration (e.g., in the Y-direction), the cover 14 is in an unlocked state.

In various implementations, the platform 68 includes a polygonal-shaped configuration (e.g., square, rectangular, etc.) and a set of crevices 74. In some example configurations, the crevices 74 are arranged parallel to each other. In various implementations, a user may engage the platform 68 and may apply a force F (e.g., in the Y-direction) to the platform 68 to move the cover 14 between the open configuration and the closed configuration. With reference to FIG. 4, the user may apply a force F to the platform 68 in a first direction 80 (e.g., parallel to the Y-direction) to move the cover 14 from the open configuration to the closed configuration. The user may apply a force F to the platform 68 in a second direction 82 (e.g., parallel to the Y-direction), opposite the first direction 80, to move the cover 14 from the closed configuration to the open configuration.

In various implementation, when the force F is equal to or exceeds a determined threshold, the cover 14 may transition from the locked state to the unlocked state such that the cover 14 is permitted to move relative to the housing 12 (e.g., in the Y-direction). The determined threshold is associated with a force that enables the detent 64 to be moved out of the first recess 42A or the second recess 42B. In various implementations, the set of crevices 74 help facilitate the user's engagement with the platform 68 such that the user may apply a force F to the platform 68 to move the cover 14 relative to the housing 12.

With reference to FIGS. 1 and 4, in various implementations, the electrical conductor 16 (e.g., a busbar, etc.) comprises one or more of a variety of shapes, sizes, configurations, and/or materials. In some example configuration, the electrical conductor 16 may include an elongated-shaped configuration. The electrical conductor 16 may include a hole 90. The hole 90 may be disposed proximate a terminal end 92 of the electrical conductor 16. In the assembled configuration, the electrical conductor 16 is disposed in the cavity 30 of the housing 12 such that the hole 90 is aligned with the aperture 32 of the housing 12. The hole 90 may receive portions of the fastener 18 and/or the terminal 20, among others.

With reference to FIG. 2, in the assembled configuration, the electrical conductor 16 may be electrically connected with a power source 100 (e.g., a battery, etc.) and one or more electrical devices 102. The electrical conductor 16 may transmit and/or may distribute electrical current from the power source 100 to the electrical devices 102. In various implementations, an electrical device 102 may include an electrical component and/or an electrical system of a vehicle 104 (e.g., an automobile).

With reference to FIGS. 1, 2, and 5, in various implementations, the fastener 18 comprises one or more of a variety of shapes, sizes, configurations, and/or materials. In various implementations, the fastener 18 comprises an electrically conducting material (e.g., metal, etc.). In the assembled configuration, the fastener 18 may be electrically connected with the electrical conductor 16, the terminal 20, the power source 100, and/or the electrical device 102, among others.

With reference to FIGS. 1, 2, and 5, in various implementations, the terminal 20 comprises one or more of a variety of shapes, sizes, configurations, and/or materials. In some example configurations, the terminal 20 defines an aperture 110. The aperture 110 may receive a portion of the fastener 18. In various implementations, the terminal 20 may comprise an electrically conducting material (e.g., metal, etc.). In the assembled configuration, the terminal 20 may be connected with the housing 12 (e.g., the second portion 12B). The terminal 20 may be press-fitted into the opening 50 of the housing 12. The terminal 20 may be electrically connected with the electrical conductor 16, the fastener 18, the power source 100, and/or the electrical device 102, among others.

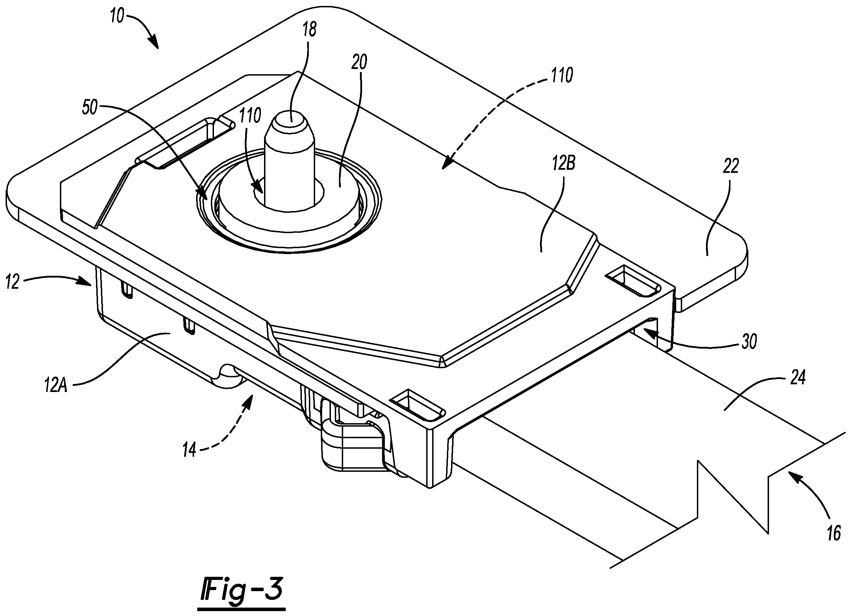

With reference to FIGS. 1 and 3, in various implementations, the plate 22 comprises one or more of a variety of shapes, sizes, configurations, and/or materials. In some example configurations, the plate 22 defines an opening 120. The opening 120 may include a configuration that is similar to a configuration of a structure 122 of the housing 12 (e.g., the second portion 12B). The plate 22 may comprise an electrically insulating material (e.g., Mica, etc.). In the assembly configuration, a portion of the plate 22 may be disposed in the cavity 30 of the housing 12 and a portion of the plate 22 may be disposed outside of the housing 12. Portions of the fastener 18, the terminal 20, and the structure 122 of the housing 12 may be disposed in the opening 120 of the plate 22.

With reference to FIGS. 1 and 3, in various implementations, a sleeve (e.g., sleeves 24, 26) comprises one or more of a variety of shapes, sizes, configurations, and/or materials. In some example configurations, the sleeve comprises an electrically insulating material. In the assembly configuration, a portion of the electrical conductor 16 may be disposed in the sleeve. A portion of the sleeve may be disposed in the cavity 30 of the housing 12.

With reference to FIGS. 2 and 4-7, in various implementations, the electrical assembly 10 is disposed in and/or incorporated with the vehicle 104. In various implementations, the electrical assembly 10 enables electrical current from the power source 100 to be transmitted to the electrical device 102. In various implementations, a fault condition (e.g., a high current fault condition, a short circuit, an overloading condition, a ground fault condition, a component failure, etc.) may produce contaminants (e.g., molten aluminum, etc.) that could negatively impact operation of the vehicle 104 if the contaminants come into contact with certain electrical components, systems, and/or connections of the vehicle 104.

In various implementations, the electrical assembly 10 inhibits contaminants (e.g., molten aluminum, etc.) from negatively impacting an electrical connection 130 between the electrical conductor 16, the fastener 18, the terminal 20, and/or the power source 100, among others. For example, when the cover 14 is in the closed configuration (see, e.g., FIGS. 6 and 7), the electrical connection 130 is enclosed (e.g., sealed) in the cavity 30 of the housing 12 such that that contaminants are inhibited from contacting the electrical connection 130. The plate 22 inhibits the contaminants from contacting portions of the electrical connection 130 and/or the power source 100, among others.

In various implementations, the electrical assembly 10 is assembled and/or serviced when the cover 14 is in the open configuration. For example, the fastener 18 may be inserted into the aperture 32 and/or may be accessed when the cover 14 is in the open configuration.

The term non-transitory computer-readable medium does not encompass transitory electrical or electromagnetic signals propagating through a medium (such as on a carrier wave). Non-limiting examples of a non-transitory computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The term "set" generally means a grouping of one or more elements. The elements of a set do not necessarily need to have any characteristics in common or otherwise belong together. The phrase "at least one of A, B, and C" should be construed to mean a logical (A OR B OR C), using a non-exclusive logical OR, and should not be construed to mean "at least one of A, at least one of B, and at least one of C." The phrase "at least one of A, B, or C" should be construed to mean a logical (A OR B OR C), using a non-exclusive logical OR.

The following Clauses provide an exemplary configuration for an electrical assembly, as described above.

Clause 1: A cover comprising: a base; a pair of rails extending from the base and configured to be moveably-coupled to a housing; and a leg extending from the base and including a detent configured to restrict movement of the cover relative to the housing.

Clause 2: The cover of clause 1, wherein the leg is disposed between the pair of rails.

Clause 3: The cover of clause 1 or 2, wherein: the leg defines a first length; each rail of the pair of rails defines a second length; and the first length is less than the second length.

Clause 4: The cover of any of clauses 1 through 3, wherein the pair of rails are configured to engage a pair of tracks of the housing.

Clause 5: The cover of any of clauses 1 through 4, wherein each rail of the pair of rails defines an L-shaped cross section.

Clause 6: The cover of any of clauses 1 through 5, further comprising a platform extending from the base.

Clause 7: The cover of clause 6, wherein: the pair of rails and the leg extend from the base in a first direction; the platform extends from the base in a second direction; and the second direction is opposite the first direction.

Clause 8: The cover of clause 6, wherein the platform is configured to be engaged by a user to move the cover relative to the housing.

Clause 9: The cover of clause 6, wherein: the platform includes a plurality of crevices; and the plurality of crevices are arranged parallel to each other.

Clause 10: The cover of clause 6, wherein the platform includes a polygonal-shaped configuration.

Clause 11: An electrical assembly comprising: an electrical conductor; a housing removably coupled to the electrical conductor and defining a cavity and an aperture, the cavity receiving at least a portion of the electrical conductor, the aperture in fluid communication with the cavity; and a cover slidably coupled to the housing and configured to move between an open position and a closed position.

Clause 12: The electrical assembly of clause 11, wherein: the aperture is exposed when the cover is in the open position; and the aperture is covered when the cover is in the closed position.

Clause 13: The electrical assembly of claim 11 or 12, wherein: the electrical assembly includes a hole; and in an assembled configuration, a portion of the electrical conductor is disposed in the cavity of the housing such that the hole is aligned with the aperture of the housing.

Clause 14: The electrical assembly of clause 13, further comprising a fastener, wherein, in the assembled configuration, the fastener is disposed in the aperture and the hole.

Clause 15: The electrical assembly of any of clauses 11 through 14, wherein: the housing defines a channel, a first recess, and a second recess; the first recess and the second recess are accessible via the channel; and the channel, the first recess, and the second recess receive portions of the cover.

Clause 16: The electrical assembly of clause 15, wherein: the cover includes: a base; a leg extending from the base; and a detent extending from the leg; the leg is disposed in the channel of the housing; and the cover is inhibited from moving relative to the housing when the detent is disposed in the first recess or the second recess.

Clause 17: The electrical assembly of clause 16, wherein: the cover is in the open position when the detent is disposed in the first recess; and the cover is in the closed position when the detent is disposed in the second recess.

Clause 18: The electrical assembly of clause 15, wherein: the housing defines a second channel and a third channel; the channel is disposed between the second channel and the third channel; the cover includes a first rail and a second rail extending from a base; and in an assembled configuration, the first rail is disposed in the second channel and the second rail is disposed in the third channel.

Clause 19: The electrical assembly of any of clauses 11 through 18, wherein: the housing defines a track; the cover includes a rail; and in an assembled configuration, the rail engages the track to inhibit the cover from detaching from the housing.

Clause 20: The electrical assembly of clause 19, wherein: the housing defines an additional track; the cover includes an additional rail; and in the assembled configuration, the additional rail engages the additional track.

## Claims

1. A cover (14) comprising:
a base (60);
a pair of rails extending from the base (60) and configured to be moveably-coupled to a housing (12); and
a leg (62) extending from the base (60) and including a detent (64) configured to restrict movement of the cover (14) relative to the housing (12).

2. The cover (14) of claim 1 wherein the leg (62) is disposed between the pair of rails.

3. The cover (14) of claim 1 or 2 wherein:
the leg (62) defines a first length;
each rail of the pair of rails defines a second length; and
the first length is less than the second length.

4. The cover (14) of any one of the preceding claims wherein the pair of rails are
configured to engage a pair of tracks (44A, 44B) of the housing (12),
and/or wherein each rail of the pair of rails defines an L-shaped cross section.

5. The cover (14) of any one of the preceding claims further comprising a platform (68) extending from the base (60), wherein preferably:
the pair of rails and the leg (62) extend from the base (60) in a first direction (70, 80);
the platform (68) extends from the base (60) in a second direction (72, 82); and
the second direction (72, 82) is opposite the first direction (70, 80).

6. The cover (14) of claim 5 wherein the platform (68) is configured to be engaged by a user to move the cover (14) relative to the housing (12).

7. The cover (14) of claim 5 or 6 wherein:
the platform (68) includes a plurality of crevices (74); and
the plurality of crevices (74) are arranged parallel to each other.

8. The cover (14) of any one of claims 5, 6 or 7 wherein the platform (68) includes a polygonal-shaped configuration.

9. An electrical assembly (10) comprising:
an electrical conductor (16);
a housing (12) removably coupled to the electrical conductor (16) and defining a cavity (30) and an aperture (32, 110), the cavity (30) receiving at least a portion (12A, 12B) of the electrical conductor (16), the aperture (32, 110) in fluid communication with the cavity (30); and
a cover (14) slidably coupled to the housing (12) and configured to move between an open position and a closed position.

10. The electrical assembly (10) of claim 9 wherein:
the aperture (32, 110) is exposed when the cover (14) is in the open position; and
the aperture (32, 110) is covered when the cover (14) is in the closed position.

11. The electrical assembly (10) of claim 9 or 10 wherein:
the electrical assembly (10) includes a hole (90); and
in an assembled configuration, a portion (12A, 12B) of the electrical conductor (16) is disposed in the cavity (30) of the housing (12) such that the hole (90) is aligned with the aperture (32, 110) of the housing (12),
preferably further comprising a fastener (18), wherein, in the assembled configuration, the fastener (18) is disposed in the aperture (32, 110) and the hole (90).

12. The electrical assembly (10) of any one of the preceding claims 9 to 11 wherein:
the housing (12) defines a channel (40A), a first recess (42A), and a second recess (42B);
the first recess (42A) and the second recess (42B) are accessible via the channel (40A); and
the channel (40A), the first recess (42A), and the second recess (42B) receive portions (12A, 12B) of the cover (14).

13. The electrical assembly (10) of claim 12 wherein:
the cover (14) includes:
a base (60);
a leg (62) extending from the base (60); and
a detent (64) extending from the leg (62);
the leg (62) is disposed in the channel (40A) of the housing (12); and
the cover (14) is inhibited from moving relative to the housing (12) when the detent (64) is disposed in the first recess (42A) or the second recess (42B), wherein preferably:
the cover (14) is in the open position when the detent (64) is disposed in the first recess (42A); and
the cover (14) is in the closed position when the detent (64) is disposed in the second recess (42B).

14. The electrical assembly (10) of any one of the preceding claims 9 to 13 when combined with claim 12 wherein:
the housing (12) defines a second channel (40B) and a third channel (40C);
the channel (40A) is disposed between the second channel (40B) and the third channel (40C);
the cover (14) includes a first rail (66A) and a second rail (66B) extending from a base (60); and
in an assembled configuration, the first rail (66A) is disposed in the second channel (40B) and the second rail (66B) is disposed in the third channel (40C).

15. The electrical assembly (10) of any one of the preceding claims 9 to 14 wherein:
the housing (12) defines a track (44A, 44B);
the cover (14) includes a rail; and
in an assembled configuration, the rail engages the track (44A, 44B) to inhibit the cover (14) from detaching from the housing (12), wherein preferably:
the housing (12) defines an additional track;
the cover (14) includes an additional rail; and
in the assembled configuration, the additional rail engages the additional track.
